# EUROPEAN PATENT APPLICATION

(11) **EP 2 086 012 A1**
(43) Date of publication of application: **05.08.2009**
(21) Application number: 07150162.1
(22) Date of filing: 19.12.2007
(51) Int. Cl.: H01L 29/739, H01L 21/331, H01L 29/08

(54) **Reverse-conducting insulated gate bipolar transistor and method for manufacturing such a reverse-conducting insulated gate bipolar transistor**

(71) Applicant: ABB Technology AG, 8050 Zürich (CH)
(72) Inventor: Rahimo, Munaf, CH-5619, Uezwil (CH); H-Alikhani, Babak, CH-5614, Sarmerstorf (CH)
(74) Representative: ABB Patent Attorneys

(57) **Abstract**

For a method for manufacturing a reverse-conducting insulated gate bipolar transistor (RC-IGBT) (10) with a seventh layer (7,7') formed as a gate electrode and a first electrical contact (8) on a first main side (101) and a second electrical contact (9) on a second main side (102), which is opposite the first main side (101), a wafer (11) of a first conductivity type with a first side (111) and a second side (112) opposite the first side (111) is provided. For the manufacturing of the RC-IGBT (10) on the second main side (112) the following steps are performed:
A ninth layer (32) of the first conductivity type or of a second conductivity type is created on the second side (112). A mask (12) with an opening (121) is created on the ninth layer (32) and those parts of the ninth layer (32), on which the opening (121) of the mask (12) is arranged, are removed, the remaining parts of the ninth layer (32) forming a third layer (3). Afterwards for the manufacturing of a second layer (2) of a different conductivity type than the third layer (3), ions are implanted into the wafer (11) on the second side (112) into those parts of the wafer (11), on which the at least one opening (121) is arranged.

## Description

### Technical Field

The invention relates to the field of power electronics and more particularly to a method for manufacturing a reverse-conducting insulated gate bipolar transistor according to the preamble of claim 1 and to a reverse-conducting insulated gate bipolar transistor according to the preamble of claim 12 and to a converter with such a reverse-conducting insulated gate bipolar transistor according to claim 16.

### Background Art

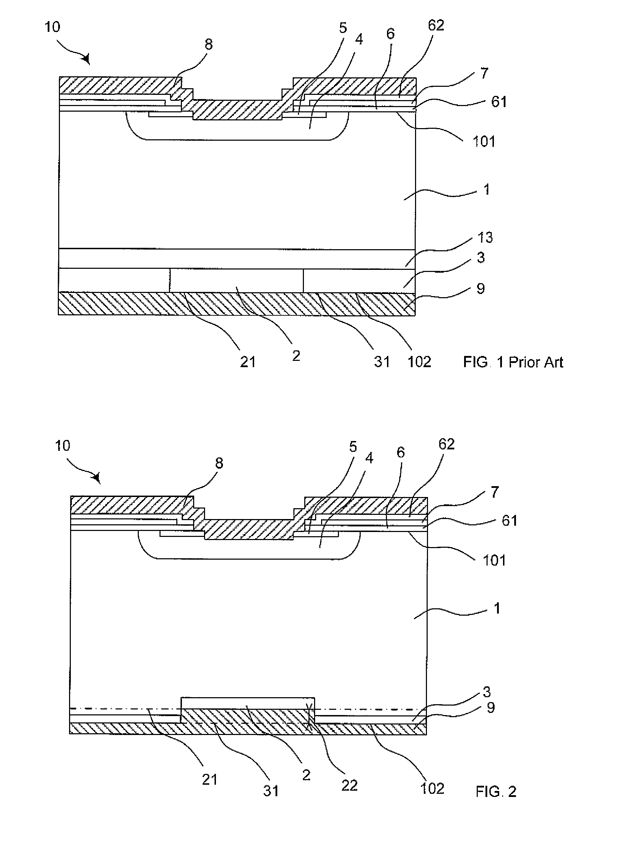

In US 2005/0017290 a reverse-conducting insulated gate bipolar transistor 10 (RC-IGBT) is described, which comprises within one wafer an insulated gate bipolar transistor with a built-in freewheeling diode. As shown in Fig. 1, such a reverse-conducting insulated gate bipolar transistor 10 comprises a first layer 1 formed as an n type base layer with a first main side 101 and a second main side 102 opposite the first main side 101. A fourth p type layer 4 is arranged on the first main side 101. On the fourth layer 4 a fifth n type layer 5 with a higher doping than the first layer 1 is arranged on the first main side 101.

A sixth electrically insulating layer 6 is arranged on the first main side 101 and covers the fourth layer 4 and the first layer 1 and partially covers the fifth layer 5. An electrically conductive seventh layer 7 is completely embedded in the sixth layer 6. Above the central part of the fourth layer 4 no fifth or sixth layer 5, 6 is arranged.

On this central part of the fourth layer 4, a first electrical contact 8 is arranged, which covers the sixth layer 6. The first electrical contact 8 is in direct electrical contact to the fifth layer 5 and the fourth layer 4, but is electrically insulated from the seventh layer 7.

On the second main side 102, an eighth layer 13 formed as a buffer layer is arranged on the first layer 1. On the eighth layer 13, p type third layers 3 and n type second layers 2 are arranged alternately in a plane. The second layers 2 have a higher doping than the first layer 1. The second layers 2 are arranged directly below the fourth layer 4 and the first electrical contact 8 if seen in orthographic projection.

A second electrical contact 9 is arranged on the second main side 102 and it covers the second and third layers 2, 3 and is in direct electrical contact to them.

In such a reverse-conducting insulated gate bipolar transistor 1 a freewheeling diode is formed between the second electrical contact 9, part of which forms a cathode electrode in the diode, the second layer 2, which forms a cathode region in the diode, the first layer 1, part of which forms a base layer in the diode, the fourth layer 4, part of which forms an anode region in the diode and the first electrical contact 8, which forms an anode in the diode.

An insulated gate bipolar transistor is formed between the second electrical contact 9, part of which forms a collector electrode in the IGBT, the third layer 3, which forms a collector region in the IGBT, the first layer 1, part of which forms a base layer, the fourth layer 4, part of which forms a p-base region in the IGBT, the fifth layer 5, which forms a source region in the IGBT, and the first electrical contact 8, which forms an emitter electrode. During on-state of the IGBT a channel is formed between the emitter electrode, the source region and the p-base region towards the n-base layer.

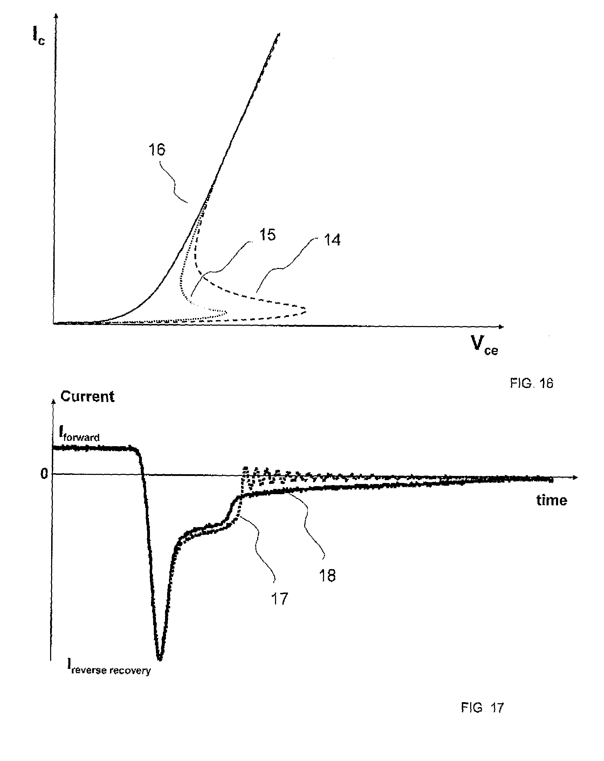

The layers of the RC-IGBT on the second main side 102 are typically manufactured by implanting and diffusing p type ions. Afterwards a resist mask is introduced, through which n type ions are implanted and afterwards diffused. The implantation dose of the n type ions has to be so high that it compensates the p type region. The p and n type implantation steps can also be reversed. Due to the necessary overcompensation, limited selection for dose and depth of the latter manufactured layer of the second and third layer 2, 3 are only possible and the control for the p and n region injection efficiencies is unsatisfactory. On-state snap-back effects, defined by the point, at which the conduction voltage and current characteristics change from MOS operation mode to IGBT operation mode, can occur, which are undesirable for the device in the IGBT mode. Fig. 16 shows the output characteristics of the RC-IGBT current I_{c} to voltage V_{ce}. The dashed line 14 shows the strong overshoot resulting from the snap-back effect, as it is typical for a prior art RC-IGBT during the change from MOS to IGBT operation mode. Fig. 17 shows the RC-IGBT current waveform in the diode mode during reverse recovery of the device. A prior art RC-IGBT shows a snappy behaviour of the device during reverse recovery (dotted line 17).

### Disclosure of Invention

It is an object of the invention to provide a method for manufacturing a reverse-conducting insulated gate bipolar transistor, which is less susceptible for on-state snap-back effects than prior art RC-IGBTs and which provides better control for the above mentioned electrical properties of the diode and IGBT, and to provide such a reverse-conducting insulated gate bipolar transistor.

This object is achieved by a method for manufacturing a reverse-conducting insulated gate bipolar transistor according to claim 1, by a reverse-conducting insulated gate bipolar transistor according to claim 12 and by a converter with such a reverse-conducting insulated gate bipolar transistor according to claim 16.

For the inventive method for manufacturing a reverse-conducting insulated gate bipolar transistor with a seventh layer formed as a gate electrode and a first electrical contact on a first main side and a second electrical contact on a second main side, which is opposite the first main side, a wafer of a first conductivity type with a first side and a second side opposite the first side is provided.

For the manufacturing of the reverse-conducting insulated gate bipolar transistor on the second main side the following steps are performed:
- a ninth layer of the first conductivity type or of a second conductivity type is created on the second side,
- a mask with at least one opening is created on the ninth layer and those parts of the ninth layer, on which an opening of the mask is arranged, are removed, the remaining parts of the ninth layer forming a third layer,
- afterwards for the manufacturing of a second layer of a different conductivity type than the third layer, ions are implanted into the wafer on the second side into those parts of the wafer, on which the at least one opening is arranged,
- afterwards the mask is removed and
- a second electrical contact, which is in direct electrical contact to the second and third layer, is created on the second side.

Typically, after the removal of the mask an anneal step for the activation of the second layer 2 is performed.

The reverse-conducting insulated gate bipolar transistor according to the invention comprises a seventh layer formed as a gate electrode and a first electrical contact on a first main side, a second electrical contact on a second main side, which is opposite the first main side, at least one third layer of a first or second conductivity type and at least one second layer of a different conductivity type than the third layer, which are arranged on the second main side, the at least one second and third layers being arranged alternately, and a second electrical contact, which is arranged on the second main side and which is in direct electrical contact to the at least one second and third layer. The at least one second layer is arranged in a first plane parallel to the second main side and the at least one third layer is arranged in a second plane parallel to the second main side. The first plane and the second plane are spaced from each other by at least the thickness of that layer of the at least one second or third layer, which is arranged farer away from the first main side.

With such a manufacturing method for an inventive RC-IGBT, an RC-IGBT can be provided with good control for the second and third layers, i.e. the cathode layer in the diode and the collector layer in the IGBT part of the device. No overcompensation of any layer is required and the layers can be made thin. Especially when the inventive RC-IGBT is manufactured with second and third layers, one of these layer types having a stronger p doping than the n doping of the other layer type, snap-back effects are further minimized or even eliminated (dotted line 15 and solid line 16 in Fig. 16. That at least one layer of the second or third layer, which is of a different conductivity type than the first layer, is created with a higher dose than that at least one layer of the second and third layer, which is of the same conductivity type as the first layer. It is preferred to have stronger p doping than n doping also for diode properties as well as for IGBT properties. Furthermore, stronger p doping provides soft diode recovery reducing or eliminating overshooting of the current during reverse recovery due to hole injection from that layer of the second and third layer, which is p doped, (Fig. 17, solid line 18).

Further preferred embodiments of the inventive subject matter are disclosed in the dependent claims.

### Brief Description of Drawings

The subject matter of the invention will be explained in more detail in the following text with reference to the attached drawings, in which:
- FIG 1: shows a cross sectional view on a prior art reverse-conducting IGBT;
- FIG 2: shows a cross sectional view of an embodiment of a reverse-conducting IGBT according to the invention;
- FIG 3: shows a cross sectional view of another embodiment of a reverse-conducting IGBT according to the invention;
- FIG 4: shows a cross sectional view of another embodiment of a reverse-conducting IGBT according to the invention;
- FIG 5: shows a cross sectional view of another embodiment of a reverse-conducting IGBT according to the invention;
- FIG 6: shows a cross sectional view of another embodiment of a reverse-conducting IGBT according to the invention;
- FIG 7: shows a manufacturing step in a manufacturing method of a reverse-conducting IGBT according to the invention;
- FIG 8: shows another manufacturing step in a manufacturing method of a reverse-conducting IGBT according to the invention;
- FIG 9: shows a further manufacturing step in a manufacturing method of a reverse-conducting IGBT according to the invention;
- FIG 10: shows a manufacturing step in a manufacturing method of a reverse-conducting IGBT according to the invention;
- FIG 11: shows a manufacturing step in a manufacturing method of a reverse-conducting IGBT according to the invention;
- FIG 12: shows a manufacturing step in a manufacturing method of a reverse-conducting IGBT according to the invention;
- FIG 13: shows a manufacturing step in a manufacturing method of a reverse-conducting IGBT according to the invention;
- FIG 14: shows a manufacturing step in a manufacturing method of a reverse-conducting IGBT according to the invention;
- FIG 15: shows a cross sectional view of another embodiment of a reverse-conducting IGBT according to the invention;
- FIG 16: shows the current/voltage output characteristics of a prior art RC-IGBT and an RC-IGBT according to the invention; and
- FIG 17: shows the RC-IGBT current waveform in diode mode during reverse recovery of a prior art RC-IGBT and an RC-IGBT according to the invention.

The reference symbols used in the figures and their meaning are summarized in the list of reference symbols. Generally, alike or alike-functioning parts are given the same reference symbols. The described embodiments are meant as examples and shall not confine the invention.

### Modes for Carrying out the Invention

In Fig. 2 a first embodiment of an inventive reverse-conducting insulated gate bipolar transistor 10 (RC-IGBT) is shown. The RC-IGBT 10 comprises an n type first layer 1 with a first main side 101 and a second main side 102 opposite the first main side 101. A p type fourth layer 4 is arranged on the first main side 101. At least one n type fifth layer 5 is arranged on the first main side 101 and is surrounded by the fourth layer 4. The at least one fifth layer 5 has a higher doping than the first layer 1. A sixth electrically insulating layer 6 is arranged on the first main side 101 on top of the first, fourth and fifth layer 1, 4, 5. It at least partially covers the at least one fifth layer 5, the fourth layer 4 and the first layer 1. An electrically conductive seventh layer 7 is arranged on the first main side 101 electrically insulated from the at least one fourth layer 4, the fifth layer 5 and the first layer 1 by the sixth layer 6. Preferably, the seventh layer 7 is embedded in the sixth layer 6.

Typically the sixth layer 6 comprises a first electrically insulating layer 61, preferably made of a silicon dioxide, and a second electrically insulating layer 62, preferably also made of a silicon dioxide, preferably of the same material as the first electrically insulating layer 61. The second electrically insulating layer 62 covers the first electrically insulating layer 61. For an RC-IGBT 10 with a seventh layer 7 formed as a planar gate electrode as shown is Fig. 2 the first electrically insulating layer 61 is arranged on top of the first main side 101. In between the first and second electrically insulating layers 61, 62, which form the sixth layer 6, the seventh layer 7, which forms a gate electrode, is embedded, typically it is completely embedded. Thus, the seventh layer 7 is separated from the first, fourth and fifth layer 1, 4, 5 by the first electrically insulated layer 61. The seventh layer 7 is typically made of a heavily doped polysilicon or a metal like aluminum.

The at least one fifth layer 5, the seventh layer 7 and the sixth layer 6 are formed in such a way that an opening is created above the fourth layer 4. The opening is surrounded by the at least one fifth layer 5, the seventh layer 7 and the sixth layer 6.

A first electrical contact 8 is arranged on the first main side 101 within the opening so that it is in direct electrical contact to the fourth layer 4 and the fifth layer 5. This first electrical contact 8 typically also covers the sixth layer 6, but is separated and thus electrically insulated from the seventh layer 7 by the second electrically insulating layer 62.

At least one p type third layer 3 and at least one n type second layer 2 are arranged on the second main side 102 and the second layer 2 has a higher doping than the first layer 1. The at least one second layer 2 is arranged in a first plane 21 parallel to the second main side 102, and the at least one third layer 3 is arranged in a second plane 31 also parallel to the second main side 102. The first plane 21 and the second plane 31 are spaced from each other at least by the thickness of that layer of the at least one second or third layer 2, 3, which is arranged farer away from the first main side 101. The at least one second and third layers 2, 3 are arranged alternately, i.e. the second and third layers 2, 3 do not overlap and there is no area, in which the second layer and third layer 2, 3 are arranged above each other.

The first and second plane 21, 31 in this description shall be understood as the plane, which corresponds to that surface of the respective layer, which lies opposite the first layer 1, ie. in the finalized device, that side of the layer is meant, on which the second electrical contact 9 is arranged.

In Fig. 2 it is shown that the p type third layers 3 are arranged farer away from the first main side 101. The first plane 21 of the second layer 2 has a distance 22 from the second plane 31 of the third layer 3, which is greater than the thickness of the third layers 3 so that no part of the third layers 3 extends into the first plane 21.

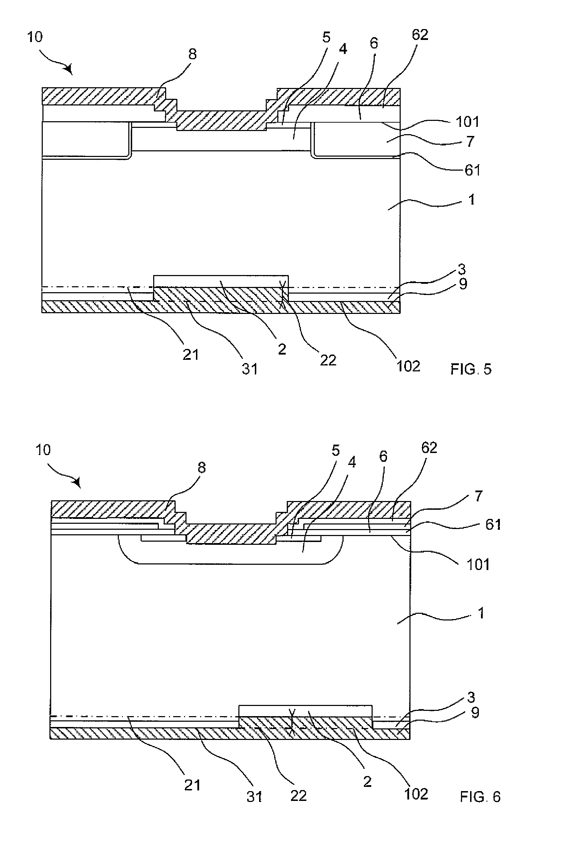

In a preferred embodiment, the second layer 2 is arranged directly below the first electrical contact 8, but the position of the second layer 2 can also be shifted to a side as shown in Fig. 6. It is not necessary to have the second layer 2 aligned to the first electrical contact 8.

In another preferred embodiment, the first plane 21 and the second plane 31 are spaced from each other by a distance between 0.5 µm up to 2 µm. In this case, the third or second layer 2, 3, which is farer away form the first main side 101 has a thickness of less than 0.5 µm up to 2 µm, depending on the distance of the first and second plane 21, 31.

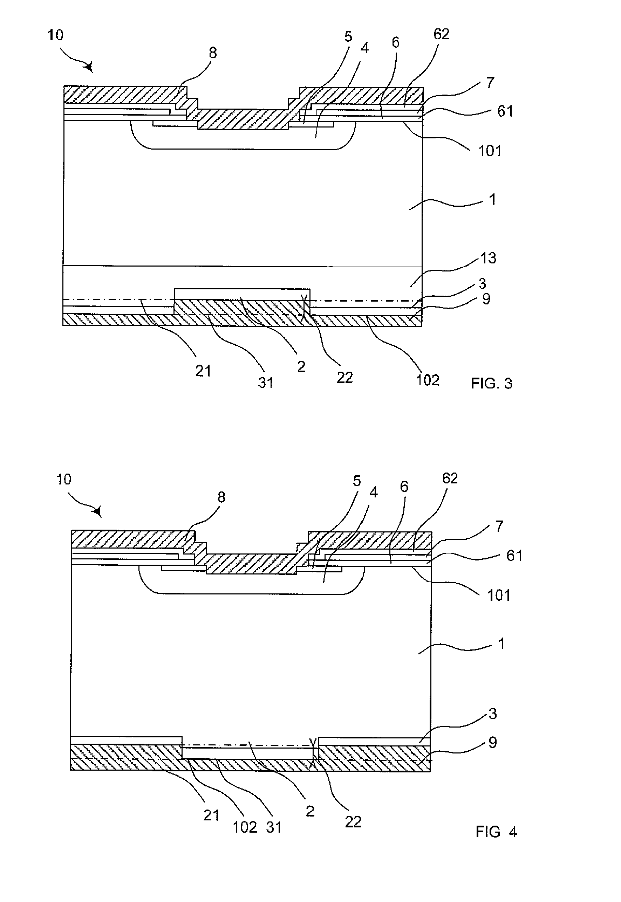

In another preferred embodiment the position of the first and second planes 21, 31 as disclosed above is reversed so that the first plane 21 and thus the second layer 2, is positioned farer away from the first main side 101 than the second plane 31, i.e. the third layer 3 (Fig. 4).

A second electrical contact 9 is arranged on the second main side 102 and it is in direct electrical contact to the at least one second and third layers 2, 3.

As an alternative, the conductivity types of the second and third layers 2, 3 are reversed, i.e. in this case the second layer 2 is of p type and the third layer 3 is of n type.

Alternatively to the inventive RC-IGBT with a planar gate electrode, the inventive RC-IGBT may comprise a seventh layer 7', formed as trench gate electrode as shown in Fig. 5. The trench gate electrode 7' is arranged in the same plane as the fourth layer 4 and adjacent to the fifth layer 5, separated from each other by a first insulating layer 61, which also separates the seventh layer 7' from the first layer 1.

A second insulating layer 62 is arranged on top of the seventh layer 7' formed as a trench gate electrode 7', thus insulating the seventh layer 7' from the first electrical contact 8.

As shown in Fig. 3, in another embodiment the RC-IGBT 10 further comprises an n type eighth layer 13, which is arranged between the first layer 1 and the first 21 or second plane 31 respectively, in which the at least one second and third layers 2, 3 are arranged and which eighth layer 13 has a higher doping than the first layer 1 and a lower doping than the second layer 2.

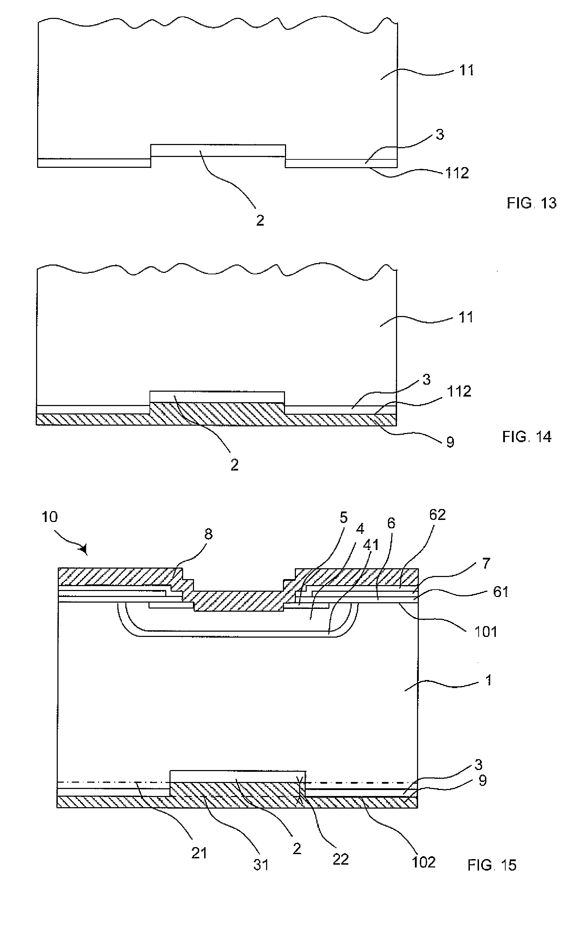

In another preferred embodiment shown in Fig. 15, a tenth n doped layer 41, formed as an enhancement layer, is arranged between the fourth layer 4 and the first layer 1 for having lower on-state losses. The tenth layer 41 separates the fourth layer 4 from the first layer 1 and it has higher doping than the first layer 1.

In another embodiment, the conductivity types of the layers are switched, i.e. all layers of the first conductivity type are p type (e.g. the first layer 1) and all layers of the second conductivity type are n type (e.g. the fourth layer 4). Also in this case, the second layer 2 may be of n type or p type and the third layer 3 of the reverse conductivity type, i.e. p type (incase of n type second layer 2) or n type (in case of p type second layer 2).

In the inventive RC-IGBT 10 a diode is formed between the first electrical contact 8, which forms an anode electrode in the diode, the fourth layer 4, part of which forms an anode layer, the first layer 1, part of which forms a base layer, that layer of the second layer 2 or third layer 3, which is of n type and which layer forms a cathode layer, and the second electrical contact 9, which forms a cathode electrode.

In the inventive RC-IGBT 10 an insulating bipolar transistor (IGBT) is formed between the first electrical contact 8, which forms an emitter electrode in the IGBT, the fifth layer 5, which forms a source region, the fourth layer 4, part of which forms a channel region, the first layer 1, part of which forms a base region, that layer of the third layer 3 or the second layer 2, which is of p type and which forms a collector layer and the second electrical contact 9, part of which forms a collector electrode.

The inventive reverse-conducting insulated gate bipolar transistor 10 can for example be used in a converter.

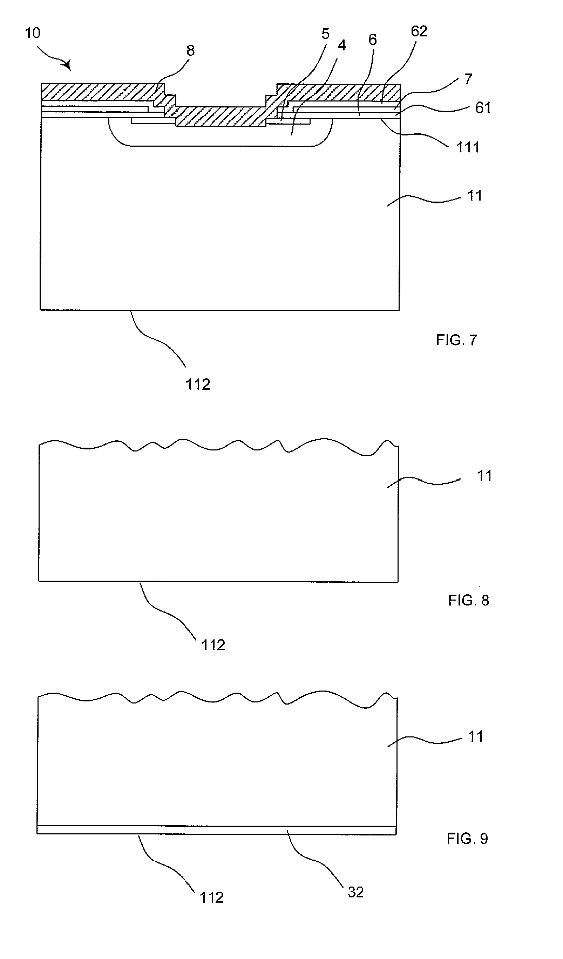

Typically for manufacturing an inventive reverse-conducting insulated gate bipolar transistor 10 with a seventh layer 7 formed as a planar gate electrode and a first electrical contact 8 on a first main side 101 and a second electrical contact 9 on a second main side 102, which is opposite the first main side 101, the following steps are performed for forming the layers on the first main side 101 of the RC-IGBT 10, resulting in a semi-fabricated RC-IGBT 10 as shown in Fig. 7.
- An n type wafer 11 with a first side 111 and a second side 112 opposite the first side 111 is provided. That part of the wafer 11, which has an unamended doping in the finalized reverse-conducting insulated gate bipolar transistor, forms a first layer 1.
- A first electrically insulating layer 61 is partially created on the first side 111.
- An electrically conductive seventh layer 7 is created on the first side 111, which is arranged on the first electrically insulating layer 61. The seventh layer 7 is typically made of a heavily doped polysilicon or a metal like aluminum.
- Afterwards a p type fourth layer 4 is created on the first side 111.
- Then at least one n type fifth layer 5, which is surrounded by the fourth layer 4, is created on the first side 111. The fifth layer 5 has a higher doping than the first layer 1.
- Preferably, a second electrically insulating layer 62 is formed on the electrically conductive seventh layer 7 in such a way, that the seventh layer 7 is arranged between the first and second electrically insulating layers 61, 62, typically the seventh layer 7 is completely embedded. The second electrically insulating layer 62 is typically made of a low-temperature silicon dioxide material as described beforehand. The first and second electrically insulating layers 61, 62 form a sixth layer 6.
- The at least one fifth layer, the sixth layer and the seventh layer 5, 6, 7 are created in such a way that they form an opening above the fourth layer 4.
- A first electrical contact 8 is created on the first side 111, which is arranged within the opening and which is in direct electrical contact to the fourth layer 4 and the fifth layer 5. Typically the first electrical contact 8 covers the sixth layer 6.

Similar steps, well-known to semiconductor experts, are performed for an RC-IGBT with trench-gate structure.

Typically, but not necessarily, the layers on the second side 112 of the wafer 11 are manufactured after manufacturing the layers on the first side 111 either before or after creating the first electrical contact 8 or at any stage during the manufacturing of the layers on the second side 112. There may be done a thinning step of the wafer 11 on the second side 112 before performing any other processing step on the second side 112 as described below. The thinning is typically done for the manufacturing of low voltage devices (e.g. for voltages below 1700 V).

In the following the inventive method for fabricating the layers of the RC-IGBT on the second main side 102 is explained. As shown in Fig. 8, an n type wafer 11 with a first side 111 and a second side 112 opposite the first side 111 is provided. In Fig. 8 only the second side 112 of the wafer 11 is shown. On the first side 111, part or all of the layers, which are arranged on that side in the finalized RC-IGBT may have been manufactured before, e.g. by using a semi-fabricated RC-IGBT as shown in Fig. 7.

That part of the wafer 11, which has an unamended doping in the finalized reverse-conducting insulated gate bipolar transistor, forms a first layer 1.

For the manufacturing of the reverse-conducting insulated gate bipolar transistor 10 on the second main side 112 the following steps are performed:

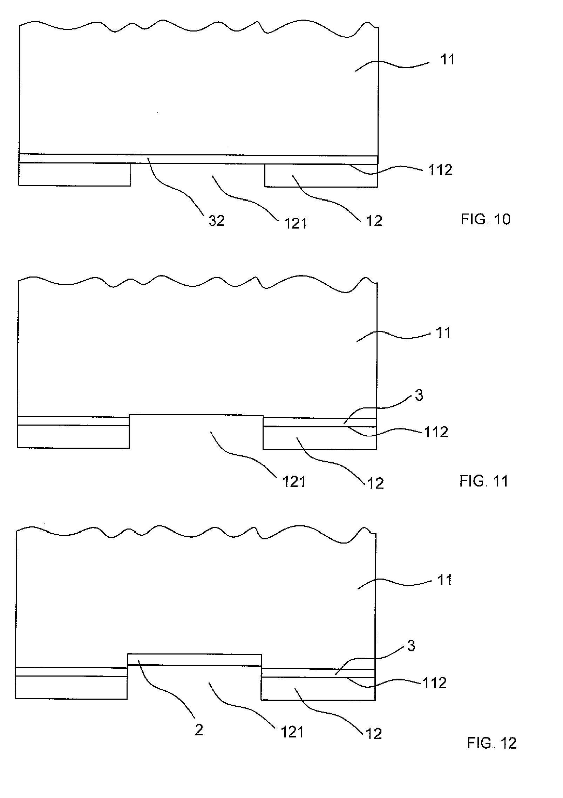

A p type ninth layer 32 is created on the second side 112. This ninth layer 32 is preferably created by implantation of ions and afterwards performing an anneal step for the activation of the layer 32, typically the anneal step is performed as a high temperature anneal with a temperature above 900 °C. Afterwards, as shown in Fig. 10, a mask 12 with at least one opening 121 is created on the ninth layer 32. Those parts of the ninth layer 32, on which an opening 121 of the mask 12 is arranged, are removed (Fig. 11), the remaining parts of the ninth layer 32 thereby forming a third layer 3. This partial removing of the ninth layer 32 is preferably done by etching, e.g. by dry or wet silicon etching. The mask 12 is attached to the wafer, preferably as a resist mask. The mask 12 is non-detachable, i.e. the mask 12 is destroyed if trying to separate the mask 12 from the wafer 11.

Afterwards, the second layer 2, which is an n type layer in this case, is manufactured by implantation of ions into the wafer 11 on the second side 112 into those parts of the wafer 11, on which the at least one opening 121 is arranged. The mask 12 is used as a mask for this process, preventing ions from penetrating into the wafer 11 on those parts, on which the mask 12 is arranged. Then the mask 12 is removed (Fig. 13) and an anneal step for the activation of the second layer 2 is performed.

For finalizing the RC-IGBT 10 a second electrical contact 9 is created on the second side 112 on the second and third layers 2, 3 so that the second electrical contact 9 is in direct electrical contact to the second and third layer 2, 3.

The third layer 3 may be created with a thickness in a range of 0.5 up to 2 µm so that the minimum distance 22 between the first and second plane, corresponding at least to the thickness of the third layer 3, needs also to be in a range 0.5 up to 2 µm.

The p type ninth layer 32 is created in a preferred embodiment by implantation of Boron ions. The ions are implanted at an energy between 20 keV up to 200 keV and/or with a dose of 1 * 10¹³ /cm² up to 1 * 10¹⁶ /cm². Afterwards the anneal step for the activation of the ninth layer 32 is performed at a temperature of at least 900 °C. Typically, the anneal step is performed before the first electrical contact 8 is created. Laser anneal can also be done, which is especially advantageous if an anneal one the second side is required, for example if the first electrical contact 8 has been created in advance and the first side shall not be extensively heated up.

The ions for the creation of the n type second layer 2 can be phosphorous. They are also implanted at an energy between 20 keV up to 200 keV and/or with a dose of 1 * 10¹³ /cm² up to 1 * 10¹⁶ /cm². The anneal step for the activation of the second layer 2 is performed at a temperature of less than 600 °C, in particular at 400 to 500 °C. The anneal step for the activation of the second layer 2 may be performed simultaneously with the creation of the second electrical contact 9 or before the creation of the second electrical contact 9.

In another preferred embodiment, the p type third layer 3 or ninth layer 32 is made with a higher dose than the dose of the n type second layer 2, in particular the p type third layer 3 or ninth layer 32 is made with a dose of more than 1 * 10¹⁴ / cm² compared to the n type second layer 2, which is made with a dose, which is typically one magnitude lower than the dose of the p type third or ninth layer 3, 32.

In general, that layer type of the at least one second or third layer 2, 3, which is of a different conductivity type than the first layer 1, is created with a higher dose than that layer type of the at least one second and third layer 2, 3, which is of the same conductivity type as the first layer 1.

Alternatively to the third layer 3 or ninth layer 32 being of p type and the second layer being of n type, in another embodiment these conductivity types are reversed so that the third layer 3 or ninth layer 32 are of n type and the second layer 2 is of p type. Also in this case, the method step as described above can be done in the same way. Preferably, in this case the p type second layer 2 is made with a high dose of more than 1 * 10¹⁴ / cm² compared to the n type third layer 3, which is made with a dose, which is typically one magnitude lower than the dose of the p type second layer 2. Both layers then can be annealed together with a temperature of at least 900 °C, in particular by a laser anneal.

### Reference List

- 1: first layer
- 2: second layer
- 21: first plane
- 22: distance
- 3: third layer
- 31: second plane
- 32: ninth layer
- 4: fourth layer
- 41: tenth layer
- 5: fifth layer
- 6: sixth layer
- 61: first electrically insulating layer
- 62: second electrically insulating layer
- 7: seventh layer
- 8: first electrical contact
- 9: second electrical contact
- 10: RC-IGBT
- 101: first main side
- 102: second main side
- 11: wafer
- 111: first side
- 112: second side
- 12: mask
- 121: opening
- 13: eighth layer
- 14: no snap-back effect
- 15: weak snap-back effect
- 16: strong snap-back effect
- 17: prior art diode snap-off
- 18: inventive RC-IGBT diode with soft recovery

## Claims

**1.** Method for manufacturing a reverse-conducting insulated gate bipolar transistor (10) with a seventh layer (7, 7') formed as a gate electrode and a first electrical contact (8) on a first main side (101) and a second electrical contact (9) on a second main side (102), which is opposite the first main side (101), in which
a wafer (11) of a first conductivity type with a first side (111) and a second side (112) opposite the first side (111) is provided, and
for the manufacturing of the reverse-conducting insulated gate bipolar transistor (10) on the second main side (102) the following steps are performed:
a ninth layer (32) of the first conductivity type or of a second conductivity type is created on the second side (112),
a mask (12) with at least one opening (121) is created on the ninth layer (32) and those parts of the ninth layer (32), on which an opening (121) of the mask (12) is arranged, are removed, the remaining parts of the ninth layer (32) forming a third layer (3),
afterwards for the manufacturing of a second layer (2) of a different conductivity type than the third layer (3), ions are implanted into the wafer (11) on the second side (112) into those parts of the wafer (11), on which the at least one opening (121) is arranged,
afterwards the mask (12) is removed and an anneal step for the activation of the second layer (2) is performed and
a second electrical contact (9), which is in direct electrical contact to the second and third layer (2, 3), is created on the second side (112).

**2.** Method for manufacturing a reverse-conducting insulated gate bipolar transistor (10) according to claim 1, **characterized in that**
the third layer (3) is of the second conductivity type and the second layer (2) is of the first conductivity type.

**3.** Method for manufacturing a reverse-conducting insulated gate bipolar transistor (10) according to claim 1, **characterized in that**
the third layer (3) is of the first conductivity type and the second layer (2) is of the second conductivity type.

**4.** Method for manufacturing a reverse-conducting insulated gate bipolar transistor (10) according to claim 2 or 3, **characterized in that**
**that** layer of the at least one second or third layer (2, 3), which is of the second conductivity type, is created with a thickness in a range between 0.5 µm up to 2 µm.

**5.** Method for manufacturing a reverse-conducting insulated gate bipolar transistor (10) according to any of the claims 1 to 3, **characterized in that**
the at least one third layer (3) is created by implantation of ions and afterwards an anneal step for the activation of the at least one third layer (3) is performed.

**6.** Method for manufacturing a reverse-conducting insulated gate bipolar transistor (10) according to any of the claims 1 to 5, **characterized in that**
the removal of those parts of the ninth layer (32), on which an opening (121) of the mask (12) is arranged, is performed by etching.

**7.** Method for manufacturing a reverse-conducting insulated gate bipolar transistor (10) according to any of the claims 2 to 3, **characterized in that**
the at least one second or the at least one third layer (2, 3) is created by implantation of Boron ions and **in that** the ions are in particular implanted at energies of 20 keV up to 200 keV and/or with doses of 1 * 10¹³ /cm² up to 1 * 10¹⁶ /cm².

**8.** Method for manufacturing a reverse-conducting insulated gate bipolar transistor (10) according to claim 2, **characterized in that**
the at least one third layer (3) is created by implantation of ions and afterwards an anneal step for the activation of the at least one third layer (3) is performed at a temperature of at least 900 °C.

**9.** Method for manufacturing a reverse-conducting insulated gate bipolar transistor (10) according to any of the claims 2 or 3, **characterized in that**
the ions for the creation of the at least one second or at least one third layer (2, 3), are Phosphorous and **in that** the ions are in particular implanted at energies of 20 keV up to 200 keV and/or with doses of 1 * 10¹³ /cm² up to 1 * 10¹⁶ /cm².

**9.** Method for manufacturing a reverse-conducting insulated gate bipolar transistor (10) according to any of the claims 2, 3, 7 or 9, **characterized in that**
the ions for the creation of the at least one second layer (2) are Phosphorous and for the creation of the at least one third layer (3) Boron or **in that** the ions for the creation of the at least one second layer (2) are Boron and **in that** the ions for the creation of the at least one third layer (3) are Phosphorous.

**10.** Method for manufacturing a reverse-conducting insulated gate bipolar transistor (10) according to claim 2, **characterized in that**
an anneal step for the activation of the at least one second layer (2) is performed, in particular at a temperature of less than 600 °C, in particular at 400 to 500 °C.

**11.** Method for manufacturing a reverse-conducting insulated gate bipolar transistor (10) according to any of the claims 1 to 10, **characterized in that**
an anneal step for the activation of the second layer (2) is performed simultaneously with the creation of the second electrical contact (9).

**12.** Reverse-conducting insulated gate bipolar transistor (10), which comprises a seventh layer (7, 7') formed as a gate electrode and a first electrical contact (8) on a first main side (101),
a second electrical contact (9) on a second main side (102), which is opposite the first main side (101),
at least one third layer (3) of a first or second conductivity type and at least one second layer (2) of a different conductivity type than the third layer (3), which are arranged on the second main side (102),
the at least one second and third layers (2, 3) being arranged alternately, and
a second electrical contact (9), which is arranged on the second main side (102) and which is in direct electrical contact to the at least one second and third layer (2, 3), **characterized in that**
the at least one second layer (2) is arranged in a first plane (21) parallel to the second main side (102),
**in that** the at least one third layer (3) is arranged in a second plane (31) parallel to the second main side (102), and **in that**
the first plane (21) and the second plane (31) are spaced from each other by at least the thickness of that layer of the at least one second or third layer (2, 3), which is arranged farer away from the first main side (101).

**13.** Reverse-conducting insulated gate bipolar transistor (10) according to claim 12, **characterized in that**
the first plane (21) and the second plane (31) are spaced from each other by a distance between 0.5 µm up to 2 µm.

**14.** Reverse-conducting insulated gate bipolar transistor (10) according to claim 12 or 13, **characterized in that**
the at least one third layer (3) is arranged farer from the first main side (101) than the at least one second layer (2).

**15.** Reverse-conducting insulated gate bipolar transistor (10) according to any of the claims 12 to 14, **characterized in that**
an eighth layer (13) of the first conductivity type is arranged between the first layer (1) and the at least one second and third layers (2, 3).

**16.** Converter with a reverse-conducting insulated gate bipolar transistor (10) according to any of the claims 12 to 15.
